# EUROPEAN PATENT APPLICATION

(11) **EP 4 848 585 A1**
(43) Date of publication of application: **02.12.2026**
(21) Application number: 26179196.6
(22) Date of filing: 18.05.2026
(51) Int. Cl.: H03H 9/02

(54) **FRAME FOR ACOUSTIC RESONATOR**

(30) Priority: 23.05.2025 US 202519217504
(71) Applicant: Avago Technologies International Sales Pte. Limited, Singapore 768923 (SG)
(72) Inventor: Kirkendall, Chris, Morgan Hill, 95037 (US); Liu, Chenchen, San Francisco, 94158 (US); Hassine, Nizar Ben, San Jose, 95127 (US)
(74) Representative: Bosch Jehle Patentanwaltsgesellschaft mbH

(57) **Abstract**

The subject technology is directed to acoustic resonators and fabrication methods thereof. The subject technology provides an acoustic resonator that includes a first electrode, a layer of piezoelectric material coupled to the first electrode, and a second electrode coupled to the layer of piezoelectric material. The layer of piezoelectric material is between the first electrode and the second electrode. A frame is located on an outer perimeter of the acoustic resonator and at least partially frames an inner area of the acoustic resonator. The frame is formed by one or more of the first electrode, the layer of piezoelectric material, and the second electrode. In various cases, the frame includes an anti-boundary mode region and a cutoff frequency of a first sub-region of the anti-boundary mode region is greater than an original cutoff frequency of the first sub-region without the anti-boundary mode region. There are other embodiments as well.

## Description

The subject technology is directed to semiconductor devices and in particular acoustic resonators.

The need to reduce the cost and size of electronic equipment has created a need for smaller single filtering elements. Bulk Acoustic Wave (BAW) resonators such as Thin-Film Bulk Acoustic Resonators (FBARs) and solidly mounted resonators (SMRs) represent one class of filter elements with potential for meeting these needs. A BAW resonator uses bulk acoustic waves in thin-film piezoelectric (PZ) material and typically includes a layer of piezoelectric material sandwiched between two metal electrodes. The piezoelectric material and electrodes are typically suspended over an air cavity or are placed over an acoustic mirror.

When an electrical field is created between the two electrodes, the piezoelectric material converts some of the electrical energy into mechanical energy in the form of acoustic waves. The acoustic waves propagate generally in the same direction as the electric field and reflect off the electrode-air or electrode-acoustic mirror interface at some frequency, including at a resonance frequency (Fs). At the resonance frequency, the device can be used as an electronic resonator. Multiple BAW resonators can be combined such that each is an element in RF filters.

BAW resonators such as FBARs can suffer from acoustic losses. The acoustic losses can have an adverse impact on the performance and reliability of the resonators and the filters they are used in. It is therefore desirable to mitigate acoustic losses in acoustic resonators, e.g., resonators used by filters in electronic devices.

Various approaches for reducing acoustic losses of BAW resonators have been explored, but they have proven to be insufficient. It is important to recognize the need for new and improved systems and methods.

According to an aspect of the invention, an acoustic resonator is provided comprising:
a first electrode;
a layer of piezoelectric material coupled to the first electrode; and
a second electrode coupled to the layer of piezoelectric material, wherein the layer of piezoelectric material is between the first electrode and the second electrode; and
a frame located on an outer perimeter of an inner area of at least one of the first electrode, the layer of piezoelectric material, or the second electrode, at least partially framing the inner area, and formed by one or more of the first electrode, the layer of piezoelectric material, and the second electrode,
wherein the frame includes an anti-boundary mode region, wherein a cutoff frequency of a first sub-region of the anti-boundary mode region is greater than an original cutoff frequency of the first sub-region without the anti-boundary mode region.

Advantageously, a ratio of a difference between the cutoff frequency of the first sub-region of the frame with the anti-boundary mode region and an original cutoff frequency of the first sub-region of the frame without the anti-boundary mode region divided by a difference between a resonant frequency of the acoustic resonator and the original cutoff frequency of the first sub-region of the frame without the anti-boundary mode region is greater than 0.2.

Advantageously, at least one of a first portion of the first electrode, the layer of piezoelectric material, or the second electrode is thinner in the anti-boundary mode region than a second portion of the first electrode, the layer of piezoelectric material, or the second electrode in a first region of the frame different from the anti-boundary mode region.

Advantageously, the frame includes a first wall and the first wall includes the anti-boundary mode region, wherein a lower surface of the anti-boundary mode region is lower than an upper surface of a first portion of the first wall.

Advantageously, a first sidewall of the first wall slopes downward from the upper surface of the first portion of the first wall to a lower surface of the anti-boundary mode region to form the anti-boundary mode region.

Advantageously, the first wall is located between a first channel and a second wall, wherein the first channel is located toward an inner area of the acoustic resonator.

According to an aspect, an acoustic resonator comprises:
a first layer including a first electrode;
a second layer including piezoelectric material coupled to the first electrode; and
a third layer including second electrode coupled to the second layer, wherein the second layer is between the first layer and the third layer; and
a frame located on an outer perimeter of an inner area of at least one of the first layer, the second layer, or the third layer, at least partially framing the inner area, and formed by one or more of the first layer, the second layer, and the third layer,
wherein the frame includes an anti-boundary mode region, wherein a first portion of at least one of the first layer, the second layer, or the third layer in the anti-boundary mode region is thinner or includes a different material than a corresponding second portion of the first layer, the second layer, or the third layer of the frame outside of the anti-boundary mode region.

Advantageously, a ratio of a difference between a cutoff frequency of a first sub-region of the frame with the anti-boundary mode region and an original cutoff frequency of the first sub-region of the frame without the anti-boundary mode region divided by a difference between a resonant frequency of the acoustic resonator and the original cutoff frequency of the first sub-region of the frame without the anti-boundary mode region is greater than 0.2.

Advantageously, the frame includes a first wall between the inner area and a second wall and the first wall includes the anti-boundary mode region, wherein a first thickness of at least one of the first layer, the second layer, or the third layer in the anti-boundary mode region is less than a second thickness of a corresponding layer in a first portion of the first wall of the frame, wherein the first portion of the first wall is located between the inner area and the anti-boundary mode region.

Advantageously, the first thickness of the first layer in the anti-boundary mode region is less than the second thickness of the first layer in the first portion of the wall.

Advantageously, the first thickness of the second layer in the anti-boundary mode region is less than the second thickness of the second layer in the first portion of the wall.

Advantageously, the first thickness of the third layer in the anti-boundary mode region is less than the second thickness of the third layer in the first portion of the wall.

Advantageously, a first material of at least one of the first layer, the second layer, or the third layer in the anti-boundary mode region is different than a second material of a corresponding layer in a first portion of the frame, wherein the first portion of the frame is located between the inner area and the anti-boundary mode region.

Advantageously, a first material of the first layer in the anti-boundary mode region is different than a second material of the first layer in a first portion of the frame, wherein the first portion of the frame is located between the inner area and the anti-boundary mode region.

Advantageously, a first material of the second layer in the anti-boundary mode region is different than a second material of the second layer in a first portion of the frame, wherein the first portion of the frame is located between the inner area and the anti-boundary mode region.

Advantageously, a first material of the third layer in the anti-boundary mode region is different than a second material of the third layer in a first portion of the frame, wherein the first portion of the frame is located between the inner area and the anti-boundary mode region.

According to an aspect, an acoustic resonator comprises:
a first electrode;
a layer of piezoelectric material coupled to the first electrode; and
a second electrode coupled to the layer of piezoelectric material, wherein the layer of piezoelectric material is between the first electrode and the second electrode; and
a frame located on an outer perimeter of an inner area of at least one of the first electrode, the layer of piezoelectric material, or the second electrode, at least partially framing the inner area, and formed by one or more of the first electrode, the layer of piezoelectric material, and the second electrode,
wherein a ratio of a difference between a cutoff frequency of a first sub-region of the frame with an anti-boundary mode region and an original cutoff frequency of the first sub-region of the frame without the anti-boundary mode region divided by a difference between a resonant frequency of the acoustic resonator and the original cutoff frequency of the first sub-region of the frame without the anti-boundary mode region is greater than 0.2.

Advantageously, a first thickness of at least one of the first electrode, the layer of piezoelectric material, or the second electrode in the anti-boundary mode region is less than a second thickness of a corresponding first electrode, a corresponding layer of piezoelectric material, or a corresponding second electrode in a first portion of a first wall of the frame, wherein the first portion of the first wall is located between the inner area of the acoustic resonator and the anti-boundary mode region.

Advantageously, a first portion of the frame is located between the inner area of the acoustic resonator and the anti-boundary mode region, and wherein a sidewall of the frame slopes downward from an upper surface of the first portion to a lower surface of the anti-boundary mode region.

Advantageously, a first material of at least one of the first electrode, the layer of piezoelectric material, or the second electrode in the anti-boundary mode region is different than a second material of a corresponding first electrode, corresponding layer of piezoelectric material, or corresponding second electrode in a first portion of the frame, wherein the first portion of the frame is located between the inner area of the acoustic resonator and the anti-boundary mode region.

### BRIEF DESCRIPTION OF THE DRAWINGS

A further understanding of the nature and advantages of particular embodiments may be realized by reference to the remaining portions of the specification and the drawings, in which like reference numerals are used to refer to similar components. In some instances, a sub-label is associated with a reference numeral to denote one of multiple similar components. When reference is made to a reference numeral without specification to an existing sub-label, it is intended to refer to all such multiple similar components.
Figure 1 illustrates a plan view of an acoustic resonator 100 in accordance with an embodiment of the present disclosure.
Figure 2 illustrates an optional cross-sectional view of the acoustic resonator of FIG. 1 taken along line A-A.
Figures 3A-3C illustrates another optional cross-sectional view of the acoustic resonator of FIG. 1 taken along line A-A.
Figures 4A-4C illustrates yet another optional cross-sectional view of the acoustic resonator of FIG. 1 taken along line A-A.
Figure 5 illustrates an additional optional cross-sectional view of the acoustic resonator of FIG. 1 taken along line A-A.
Figure 6 illustrates a graph of the cutoff frequency of a first sub-region of an anti-boundary mode region as the thickness of an anti-boundary mode region is reduced or thinned.
Figure 7 is a simplified block diagram illustrating a method to form an acoustic resonator according to embodiments of the subject technology.
Figure 8 is a simplified block diagram illustrating a method to form an acoustic resonator according to embodiments of the subject technology.
Figure 9 illustrates a dispersion diagram of different regions of an acoustic resonator including a sub-region of an anti-boundary mode region.

### DETAILED DESCRIPTION OF THE INVENTION

The subject technology is directed to acoustic resonators and fabrication methods thereof. The subject technology provides an acoustic resonator that includes a first electrode, a layer of piezoelectric material coupled to the first electrode, and a second electrode coupled to the layer of piezoelectric material. The layer of piezoelectric material is between the first electrode and the second electrode. A frame is located on an outer perimeter of the acoustic resonator and at least partially frames an inner area of the acoustic resonator. The frame is formed by one or more of the first electrode, the layer of piezoelectric material, and the second electrode. In various cases, the frame includes an anti-boundary mode region and a cutoff frequency of a first sub-region of the anti-boundary mode region is greater than an original cutoff frequency of the first sub-region without the anti-boundary mode region.

Semiconductor packages are increasingly requiring more functionality which places greater demand on the performance of the devices used in these packages. Bulk Acoustic Wave (BAW) resonators such as FBARs and SMRs are commonly used for radio frequency filtering. In particular, acoustic resonators function by utilizing acoustic waves within the semiconductor material to filter out unwanted frequencies while allowing specific frequencies to pass through. Raised boundary frames are commonly used to reduce acoustic losses above the resonant frequency (fs) of the acoustic resonator. However, the raised boundary frames can generate parasitic modes below the fs of the acoustic resonator.

In various embodiments, the subject technology provides semiconductor devices that include an acoustic resonator having an anti-boundary mode region. The anti-boundary mode region causes a cutoff frequency of a sub-region of the anti-boundary mode region to be greater than an original cutoff frequency of the sub-region without the anti-boundary mode region. Creating a higher cutoff frequency region at or after the start of the frame can mitigate parasitic modes associated with the frame, while allowing the frame structure to reduce losses above Fs. In various cases, acoustic resonators can support multiple modes of vibrations, including a main mode of interest for operation of the BAW device within an RF filter. All other modes other than the main mode are spurious or parasitic and each has a resonant frequency just like the main mode. In particular, forming the anti-boundary mode region reduces losses below Fs while maintaining the performance above Fs (i.e. ensuring that loss above fs is still minimized).

The following description is presented to enable one of ordinary skill in the art to make and use the invention and to incorporate it in the context of particular applications. Various modifications, as well as a variety of uses in different applications, will be readily apparent to those skilled in the art, and the general principles defined herein may be applied to a wide range of embodiments. Thus, the subject technology is not intended to be limited to the embodiments presented but is to be accorded the widest scope consistent with the principles and novel features disclosed herein.

In the following detailed description, numerous specific details are set forth in order to provide a more thorough understanding of the subject technology. However, it will be apparent to one skilled in the art that the subject technology may be practiced without necessarily being limited to these specific details. In other instances, well-known structures and devices are shown in block diagram form, rather than in detail, in order to avoid obscuring the subject technology.

The reader's attention is directed to all papers and documents which are filed concurrently with this specification and which are open to public inspection with this specification, and the contents of all such papers and documents are incorporated herein by reference. All the features disclosed in this specification, (including any accompanying claims, abstract, and drawings) may be replaced by alternative features serving the same, equivalent or similar purpose, unless expressly stated otherwise. Thus, unless expressly stated otherwise, each feature disclosed is one example only of a generic series of equivalent or similar features.

Furthermore, any element in a claim that does not explicitly state "means for" performing a specified function, or "step for" performing a specific function, is not to be interpreted as a "means" or "step" clause as specified in 35 U.S.C. Section 112, Paragraph 6. In particular, the use of "step of" or "act of" in the claims herein is not intended to invoke the provisions of 35 U.S.C. 112, Paragraph 6.

When an element is referred to herein as being "connected" or "coupled" to another element, it is to be understood that the elements can be directly connected to the other element, or have intervening elements present between the elements. In contrast, when an element is referred to as being "directly connected" or "directly coupled" to another element, it should be understood that no intervening elements are present in the "direct" connection between the elements. However, the existence of a direct connection does not exclude other connections, in . which intervening elements may be present.

. When an element is referred to herein as being "disposed" in some manner relative to another element (e.g., disposed on, disposed between, disposed under, disposed adjacent to, or disposed in some other relative manner), it is to be understood that the elements can be directly disposed relative to the other element (e.g., disposed directly on another element), or have intervening elements present between the elements. In contrast, when an element is referred to as being "disposed directly" relative to another element, it should be understood that no intervening elements are present in the "direct" example. However, the existence of a direct disposition does not exclude other examples in which intervening elements may be present.

Similarly, when an element is referred to herein as being "bonded" to another element, it is to be understood that the elements can be directly bonded to the other element (without any intervening elements) or have intervening elements present between the bonded elements. In contrast, when an element is referred to as being "directly bonded" to another element, it should be understood that no intervening elements are present in the "direct" bond between the elements. However, the existence of direct bonding does not exclude other forms of bonding, in which intervening elements may be present.

Likewise, when an element is referred to herein as being a "layer," it is to be understood that the layer can be a single layer or include multiple layers. For example, a conductive layer may comprise multiple different conductive materials or multiple layers of different conductive materials, a dielectric layer may comprise multiple dielectric materials or multiple layers of dielectric materials, a device layer can include one or more resistors, capacitors, inductors, diodes, transistors, integrated circuits, etc. When a layer is described as being coupled or connected to another layer, it is to be understood that the coupled or connected layers may include intervening elements present between the coupled or connected layers. In contrast, when a layer is referred to as being "directly" connected or coupled to another layer, it should be understood that no intervening elements are present between the layers. However, the existence of directly coupled or connected layers does not exclude other connections in which intervening elements may be present.

Moreover, the terms left, right, front, back, top, bottom, forward, reverse, inner, outer, clockwise and counterclockwise are used for purposes of explanation only and are not limited to any fixed direction or orientation. Rather, they are used merely to indicate relative locations and/or directions between various parts of an object and/or components. Additionally, use of the terms first, second, third, etc. are used for purposes of explanation only and to distinguish elements from one another. They are not intended to recite a certain order unless expressly stated in this disclosure.

Furthermore, the methods and processes described herein may be described in a particular order for ease of description. However, it should be understood that, unless the context dictates otherwise, intervening processes may take place before and/or after any portion of the described process, and further various procedures may be reordered, added, and/or omitted in accordance with various embodiments.

Unless otherwise indicated, all numbers used herein to express quantities, dimensions, and so forth should be understood as being modified in all instances by the term "about." Unless otherwise specified or limited, the terms 'about' and 'approximately,' as used herein with respect to a reference value, refer to variations from the reference value of ± 20% or less (e.g., ± 20%, ± 15%, ± 10%, ± 5%, etc.), inclusive of the endpoints of the range.

In this application, the use of the singular includes the plural unless specifically stated otherwise, and use of the terms "and" and "or" means "and/or" unless otherwise indicated. Moreover, the use of the terms "including" and "having," as well as other forms, such as "includes," "included," "has," "have," and "had," should be considered non-exclusive. Also, terms such as "element" or "component" encompass both elements and components comprising one unit and elements and components that comprise more than one unit, unless specifically stated otherwise.

As used herein, the phrase "at least one of" preceding a series of items, with the term "and" or "or" to separate any of the items, modifies the list as a whole, rather than each member of the list (i.e., each item). The phrase "at least one of" does not require the selection of at least one of each item listed; rather, the phrase allows a meaning that includes at least one of any one of the items, and/or at least one of any combination of the items. By way of example, the phrases "at least one of A, B, and C" or "at least one of A, B, or C" each refer to only A, only B, or only C; and/or any combination of A, B, and C. In instances where it is intended that a selection be of "at least one of each of A, B, and C," or alternatively, "at least one of A, at least one of B, and at least one of C," it is expressly described as such.

In a first aspect, an acoustic resonator can include a first electrode, a layer of piezoelectric material coupled to the first electrode, and a second electrode coupled to the layer of piezoelectric material. The layer of piezoelectric material is between the first electrode and the second electrode. A frame can be located on an outer perimeter of an inner area of at least one of the first electrode, the layer of piezoelectric material, or the second electrode and at least partially framing the inner area. The frame is formed by one or more of the first electrode, the layer of piezoelectric material, and the second electrode. In various cases, the frame includes an anti-boundary mode region and a cutoff frequency of a first sub-region of the anti-boundary mode region is greater than an original cutoff frequency of the first sub-region without the anti-boundary mode region.

In some cases, a ratio of a difference between the cutoff frequency of the first sub-region of the frame with the anti-boundary mode region and an original cutoff frequency of the first sub-region of the frame without the anti-boundary mode region divided by a difference between a resonant frequency of the acoustic resonator and the original cutoff frequency of the first sub-region of the frame without the anti-boundary mode region is greater than 0.2.

In some instances, at least one of a first portion of the first electrode, the layer of piezoelectric material, or the second electrode is thinner in the anti-boundary mode region than a second portion of the first electrode, the layer of piezoelectric material, or the second electrode in a first region of the frame different from the anti-boundary mode region.

In some cases, the frame includes a first wall and the first wall includes the anti-boundary mode region and a lower surface of the anti-boundary mode region is lower than an upper surface of a first portion of the first wall. A first sidewall of the first wall can slope downward from the upper surface of the first portion of the first wall to a lower surface of the anti-boundary mode region to form the anti-boundary mode region. The first wall can be located between a first channel and a second wall and the first channel can be located toward an inner area of the acoustic resonator.

In another aspect, an acoustic resonator can include a first layer including a first electrode, a second layer including piezoelectric material coupled to the first electrode, and a third layer including second electrode coupled to the second layer. The second layer is between the first layer and the third layer. A frame can be located on an inner area of at least one of the first layer, the second layer, or the third layer, at least partially framing the inner area, and formed by one or more of the first layer, the second layer, and the third layer. In various cases, the frame includes an anti-boundary mode region and a first portion of at least one of the first layer, the second layer, or the third layer in the anti-boundary mode region is thinner or includes a different material than a corresponding second portion of the first layer, the second layer, or the third layer of the frame outside of the anti-boundary mode region.

In some cases, a ratio of a difference between a cutoff frequency of a first sub-region of the frame with the anti-boundary mode region and an original cutoff frequency of the first sub-region of the frame without the anti-boundary mode region divided by a difference between a resonant frequency of the acoustic resonator and the original cutoff frequency of the first sub-region of the frame without the anti-boundary mode region is greater than 0.2.

In various instances, the frame includes a first wall between the inner area and a second wall and the first wall includes the anti-boundary mode region, a first thickness of at least one of the first layer, the second layer, or the third layer in the anti-boundary mode region is less than a second thickness of a corresponding layer in a first portion of the first wall of the frame, and the first portion of the first wall is located between the inner area and the anti-boundary mode region. In some cases, the first thickness of the first layer in the anti-boundary mode region is less than the second thickness of the first layer in the first portion of the wall. Alternatively, the first thickness of the second layer in the anti-boundary mode region is less than the second thickness of the second layer in the first portion of the wall. Alternatively, the first thickness of the third layer in the anti-boundary mode region is less than the second thickness of the third layer in the first portion of the wall.

In some instances, a first material of at least one of the first layer, the second layer, or the third layer in the anti-boundary mode region is different than a second material of a corresponding layer in a first portion of the frame and the first portion of the frame is located between the inner area and the anti-boundary mode region.

In some cases, a first material of the first layer in the anti-boundary mode region is different than a second material of the first layer in a first portion of the frame and the first portion of the frame is located between the inner area and the anti-boundary mode region. Alternatively, a first material of the second layer in the anti-boundary mode region is different than a second material of the second layer in a first portion of the frame and the first portion of the frame is located between the inner area and the anti-boundary mode region. Alternatively, a . first material of the third layer in the anti-boundary mode region is different than a second material of the third layer in a first portion of the frame and the first portion of the frame is located between the inner area and the anti-boundary mode region.

In yet another aspect, an acoustic resonator can include a first layer including a first electrode, a second layer including piezoelectric material coupled to the first electrode, and a third layer including second electrode coupled to the second layer. The second layer is between the first layer and the third layer. A frame can be located on an inner area of at least one of the first layer, the second layer, or the third layer, at least partially framing the inner area, and formed by one or more of the first layer, the second layer, and the third layer. In various cases, the frame includes an anti-boundary mode region and a ratio of a difference between a cutoff frequency of a first sub-region of the frame with an anti-boundary mode region and an original cutoff frequency of the first sub-region of the frame without the anti-boundary mode region divided by a difference between a resonant frequency of the acoustic resonator and the original cutoff frequency of the first sub-region of the frame without the anti-boundary mode region is greater than 0.2.

In some cases, a first thickness of at least one of the first electrode, the layer of piezoelectric material, or the second electrode in the anti-boundary mode region is less than a second thickness of a corresponding first electrode, a corresponding layer of piezoelectric material, or a corresponding second electrode in a first portion of a first wall of the frame, and . the first portion of the first wall is located between the inner area of the acoustic resonator and the anti-boundary mode region.

In some instances, a first portion of the frame is located between the inner area of the acoustic resonator and the anti-boundary mode region, and a sidewall of the frame slopes downward from an upper surface of the first portion to a lower surface of the anti-boundary mode region.

In various cases, a first material of at least one of the first electrode, the layer of piezoelectric material, or the second electrode in the anti-boundary mode region is different than a second material of a corresponding first electrode, corresponding layer of piezoelectric material, or corresponding second electrode in a first portion of the frame, and the first portion of the frame is located between the inner area of the acoustic resonator and the anti-boundary mode region.

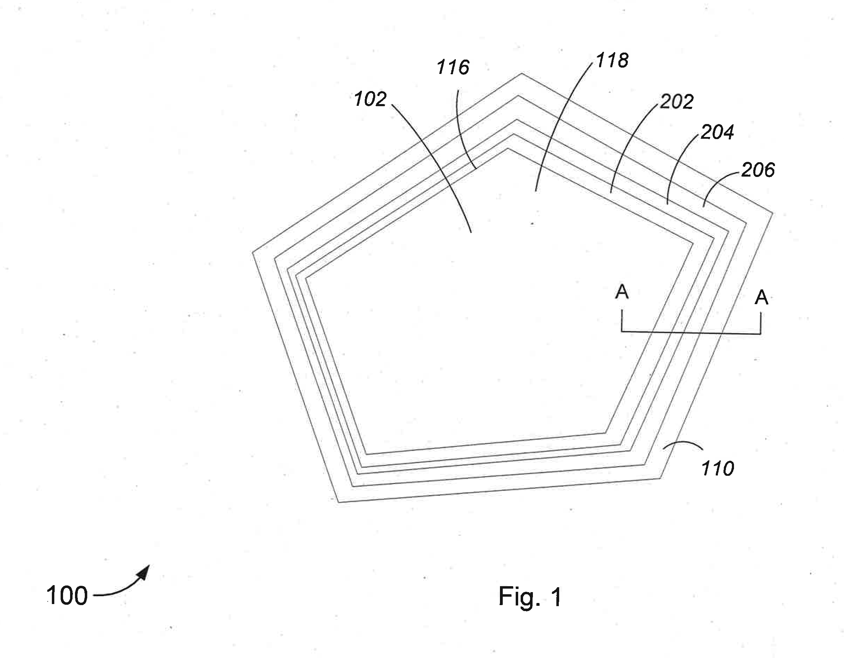

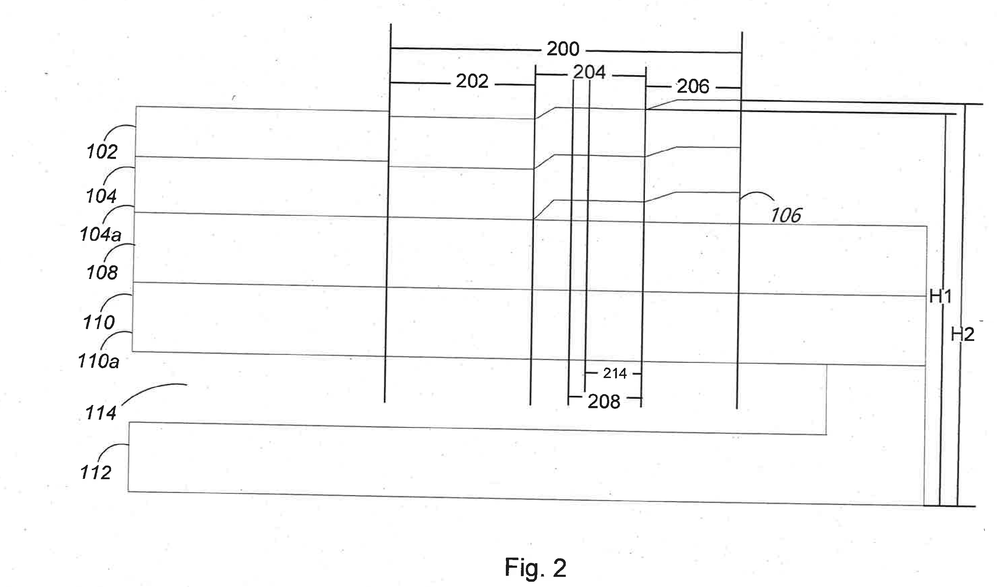

FIG. 1 illustrates a plan view of an acoustic resonator 100 in accordance with an embodiment of the present disclosure. FIG. 2 illustrates a cross-sectional view of the acoustic resonator of FIG. 1 taken along line A-A. The acoustic resonator 100 can be a Bulk Acoustic Wave (BAW) resonator such as an FBAR or an SMR as discussed above. It should be noted that the figures of this disclosure merely provide examples, which should not unduly limit the scope of the claims. One of ordinary skill in the art would recognize many variations, alternatives, and modifications.

As illustrated in FIGS. 1 and 2, the acoustic resonator 100 can include a passivation layer 102, a first layer or first electrode layer 104, a frame layer 106, a piezoelectric layer or second layer 108, a third layer or a second electrode layer 110, a substrate 112, and an air cavity or acoustic mirror 114. In various cases, when the first layer 104 is referred to as the first layer 104, the first layer 104 can be formed of an electrode material or include first electrode 104a, but may include other materials on the first layer different than the electrode material or different than the first electrode 104a. When the second layer 108 is referred to as the second layer 108, the second layer 108 can be formed of a piezoelectric material, but may include other materials on the second layer different than the piezoelectric material. When the third layer 110 is referred to as the third layer 110, the third layer 110 can be formed of an electrode material or include first electrode 110a, but may include other materials on the third layer different than the electrode material or different than the second electrode 110a. Typically, contacts can be coupled to (e.g., electrically coupled to) the first and the second electrodes 104a and 110a.

In various cases, the first electrode 104a or the first electrode layer 104 and the second electrode 110a or the second electrode layer 110 are formed from molybdenum, ruthenium, tungsten, or aluminum, or other material capable of forming an electrical connection, or a combination thereof. In some instances, the piezoelectric layer 108 is formed from aluminum nitride, aluminum scandium nitride, or other material capable of forming a piezoelectric layer, or a combination thereof. The frame layer 106 can be formed of undoped silicate glass, a dielectric material including silicon nitride, or the like, a metal material, including tungsten, molybdenum, or the like, or other material capable of forming frame layer 106. The frame layer 106 can be used to form a portion of a frame 200 described in more detail below with respect to FIGS. 1 and 2. In some cases, the frame layer 106 can be omitted from the frame 200 and other layers (e.g., first electrode layer 104, piezoelectric layer 108, or second electrode layer 110 can be used to form the frame 200. The substrate 112 can be used to build or support the one or more layers 102-110 and can be formed of silicon or other substrate material.

In various cases, the acoustic resonator 100 is pentagon-shaped. However, the acoustic resonator 100 could be any of various polygonal shapes, circular shapes, or other various smooth or irregular shapes, or the like.

In FIGS. 1 and 2, a frame 200 at least partially surrounds an outer perimeter 116 of an inner area 118 of at least one of the first electrode 104a or first electrode layer 104, the piezoelectric layer 108, or the second electrode 110a or the second electrode layer 110 of the acoustic resonator 100. In various cases, the inner area 118 of the acoustic resonator can be located above the cavity 114. In some cases, the inner area 118 is about a same size as the cavity 114 or the inner area 118 is larger or smaller than the cavity 114. The frame 200 can be formed of one or more of the passivation layer 102, the first electrode 104, the frame layer 106, the piezoelectric layer 108, and the second electrode 110. In the case of FIGS. 1 and 2, the frame 200 is formed of passivation layer 102, the first electrode 104, the frame layer 106, the piezoelectric layer 108, the second electrode 110. The frame 200 is configured to enhance acoustic resonator performance.

The frame 200 can include one or more of a channel or recess 202 located toward or framing an inner area 118 of the acoustic resonator 100, a first wall 204 extending up from the recess 202 and having a first height H1, and a second wall or wing 206 extending up from the first wall 204 and having a second height H2. In various cases, the second height H2 is higher than the first height H1. In various cases, the first wall 204 and the second wall 206 are formed by disposing frame layer 106 in a location on the piezoelectric layer 108 and the first electrode layer 104 is disposed on top of the piezoelectric layer 108 and the frame layer 106. In other embodiments, frame layer 106 may be disposed below the piezoelectric layer 108 or second electrode 110. In yet other embodiments, as discussed above, frame layer 106 may be omitted from the frame 200 and instead other layers (e.g., first electrode layer 104, piezo electrode layer 108, or second electrode layer 110, or the like) can be used to form frame 200.

In FIG. 1, the channel or recess 202, the first wall 204, and the second wall 206 are illustrated extending fully around the inner area 118 of the acoustic resonator 100. However, other embodiments are possible and the channel or recess 202, the first wall 204, and the second wall 206 may only partially extend around the inner area 118 of the acoustic resonator 100. As a person of ordinary skill in the art would understand, any number of alternative channel or recesses 202, first walls 204, and second walls 206 can be provided along the outer perimeter 116 of the inner area 118 to form the frame 200 consistent with the present disclosure. In a non-limiting example, channel or recesses 202, first walls 204, and second walls 206 can be continuously extended along some or all of the outer perimeter 116 as illustrated, channel or recesses 202, first walls 204, and second walls 206 can have smaller segments that are not continuous along the outer perimeter 116, and other shapes and configurations of channel or recesses 202, first walls 204, and second walls 206 can be used, especially where the acoustic resonator 100 is a shape other than a pentagon. In some cases, one or more of the channel or recess 202, the first wall 204, and the second wall or wing 206 can be optionally omitted from or not included in the frame 200. In other words, the frame 200 can include first wall 204 while the recess 202 and the second wall 206 are not included in the frame 200.

In some cases, frame 200 extends around the perimeter of one or more of the first electrode 104a, piezoelectric layer 108, of the second electrode. In one embodiment, the frame is located just outside the perimeter of cavity 114. In this way, when the perimeter or outside diameter of cavity 114 is extended in the vertical direction, frame 200 is "outside" the perimeter of cavity 114. In other embodiments, frame 200 overlaps the perimeter of cavity 114 such that portions of the frame are "inside" and portions of the frame are "outside" the perimeter of cavity 114. In other embodiments, frame 200 is located inside the perimeter of cavity 114. In this way, when the perimeter of cavity 114 is extended in the vertical direction, frame 200 is "inside" the perimeter of cavity 114.

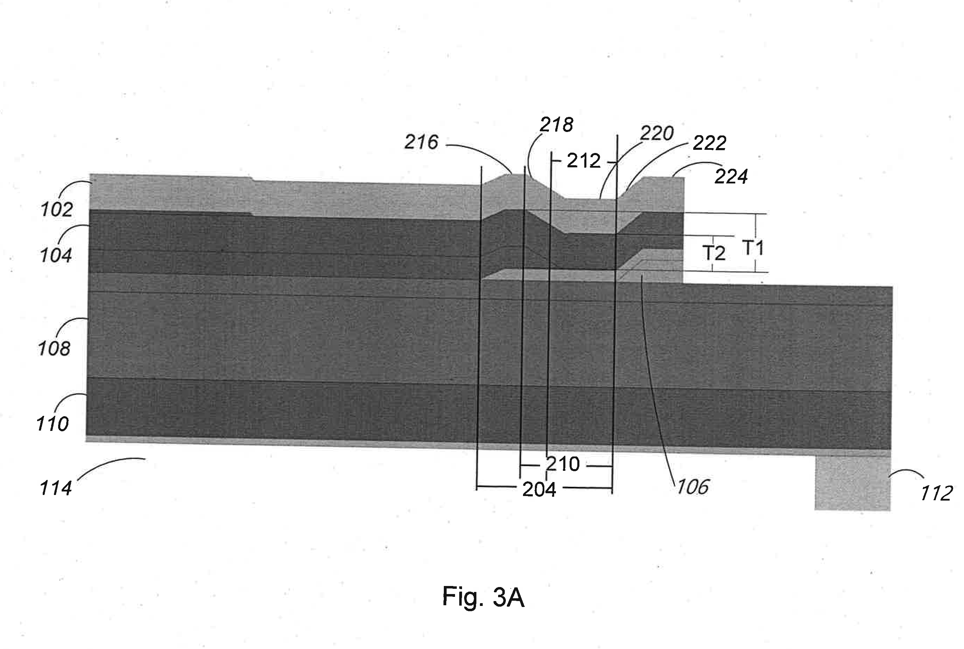

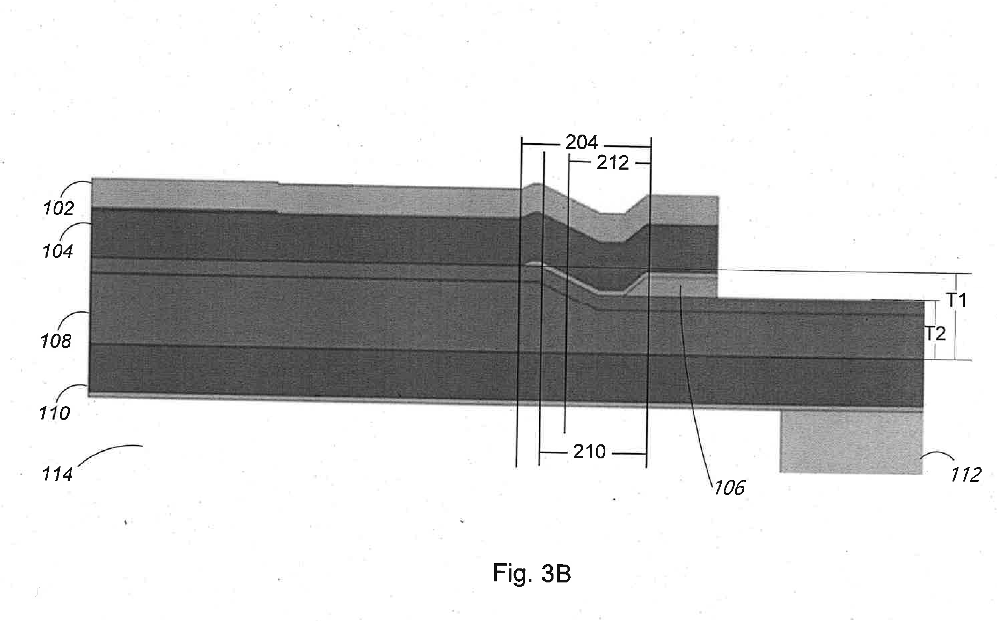

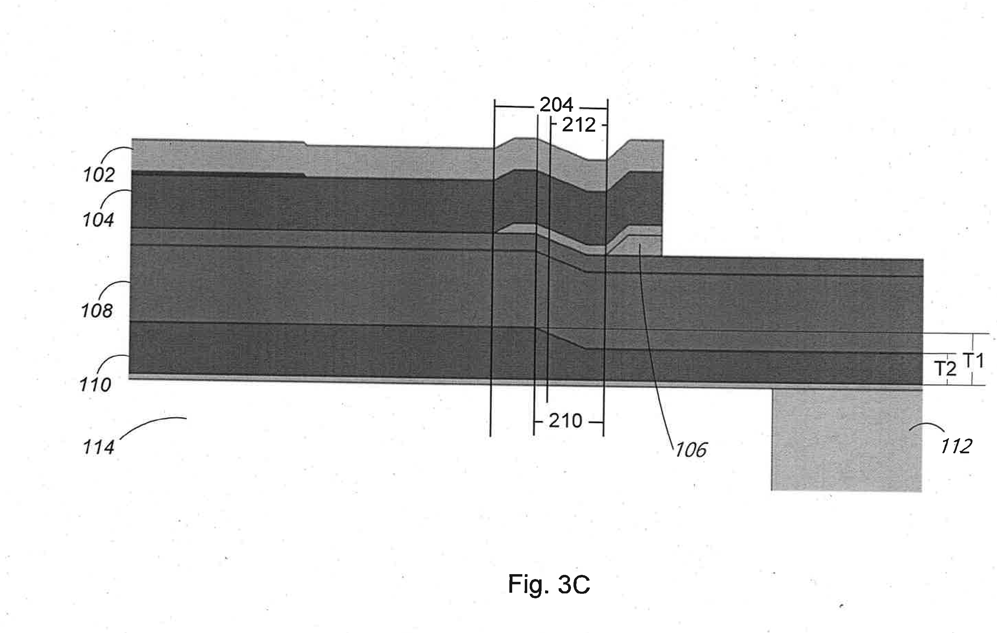

In various cases, in order to reduce parasitic modes below Fs and further optimize losses above Fs, the frame 200 can further include a first region 208 which can be formed into anti-boundary mode region 210 shown in FIGS. 3-5. The first region 208 or the anti-boundary mode region 210 can be located in the first wall 204 of the frame 200. In some instances, the first region 208 or the anti-boundary mode region 210 makes up the entire first wall 204 or, in other cases, the first region 208 or the anti-boundary mode region 210 makes up a portion of the first wall 204. In some cases, the first region 208 or the anti-boundary mode region 210 is located in another location of the frame 200.

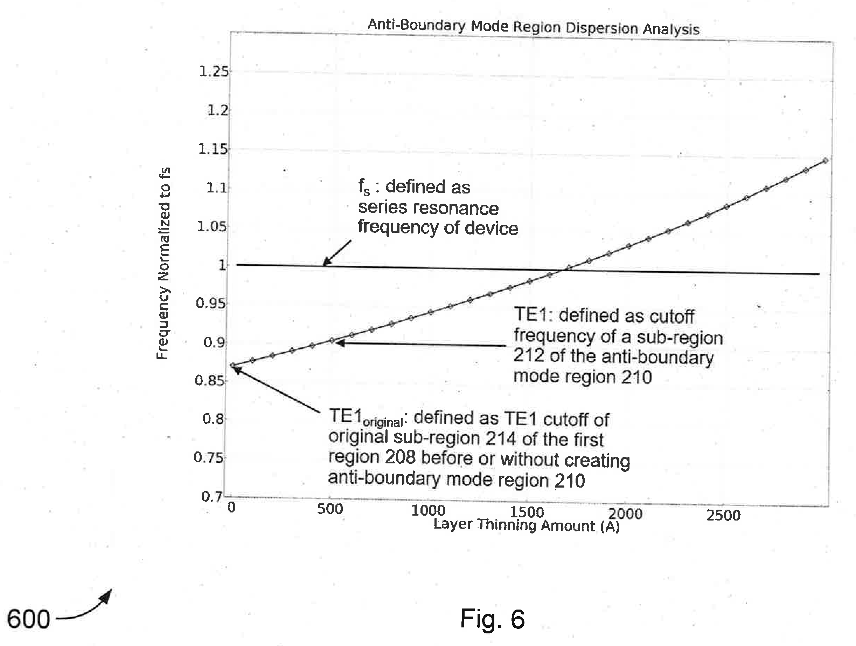

In various cases, a cutoff frequency of at least a first sub-region 212 of the anti-boundary mode region 210 is greater than an original cutoff frequency of a first sub-region 214 of the first region 208 without the anti-boundary mode region 210. In various cases, first sub-region 214 is also referred to as original sub-region 214. In various cases, the first sub-region 212 corresponds to the first sub-region 214. In other words, the first sub-region 212 is in a same location of the wall 204 and is a same size as the first sub-region 214. Thus, forming the anti-boundary mode region 210 creates a higher cutoff frequency region after the start of the first wall 204 but before the second wall 206 and can mitigate spurious modes associated with the frame 200 while still allowing the frame 200 to reduce losses above Fs. This will be discussed more below with respect to FIG. 6.

The anti-boundary mode region 210 can be formed in various ways in the frame 200 or the first wall 204 of the frame 200. For example, turning first to FIGS. 3A-3C, the anti-boundary mode region 210 can be formed by thinning or reducing the thickness of one or more of the first electrode 104, the piezoelectric layer 108, or the second electrode 110 in the first region 208 of the frame 200 or the first region 208 of the first wall 204 of the frame 200. In various cases, the first region 208 is formed into anti-boundary mode region 210 by thinning or reducing the thickness of one or multiple layers within the first region 208 of the frame 200 or the first region 208 of the first wall 204 of the frame 200.

For example, as shown in FIG. 3A, FIG. 3A shows that a thickness of the first electrode 104a is reduced in the anti-boundary mode region 210 from a first thickness T1 to a second thickness T2. FIG. 3B shows that a thickness of the piezoelectric layer 108 is reduced in the anti-boundary mode region 210 from a first thickness T1 to a second thickness T2. FIG. 3C shows that a thickness of the second electrode 110a is reduced in the anti-boundary mode region 210 from a first thickness T1 to a second thickness T2. However, a person of ordinary skill in the art would understand that other thinning options are possible for example the piezoelectric layer 108 and the second electrode layer 110 could be thinned to form the anti-boundary mode region 210.

In various cases, in order to form the anti-boundary mode region 210, as shown in FIG. 3A, the first wall 204 can include a first upper surface 216, a first sidewall 218, a lower surface 220, a second sidewall 222, and a second upper surface 224. In some cases, the second sidewall 222 and the second upper surface 224 can be included on or be a part of the second wall 206 instead of the first wall 204. In various cases, the first sidewall 218 slopes downward from the first upper surface 216 to the lower surface 220 to form the anti-boundary mode region 210. The slope of the first sidewall can be between about 10 degrees and about 90 degrees. In some instances, the second sidewall 222 slopes upward from the lower surface 220 to the second upper surface 224. The slope of the second sidewall 222 can be between about 10 degrees and about 90 degrees.

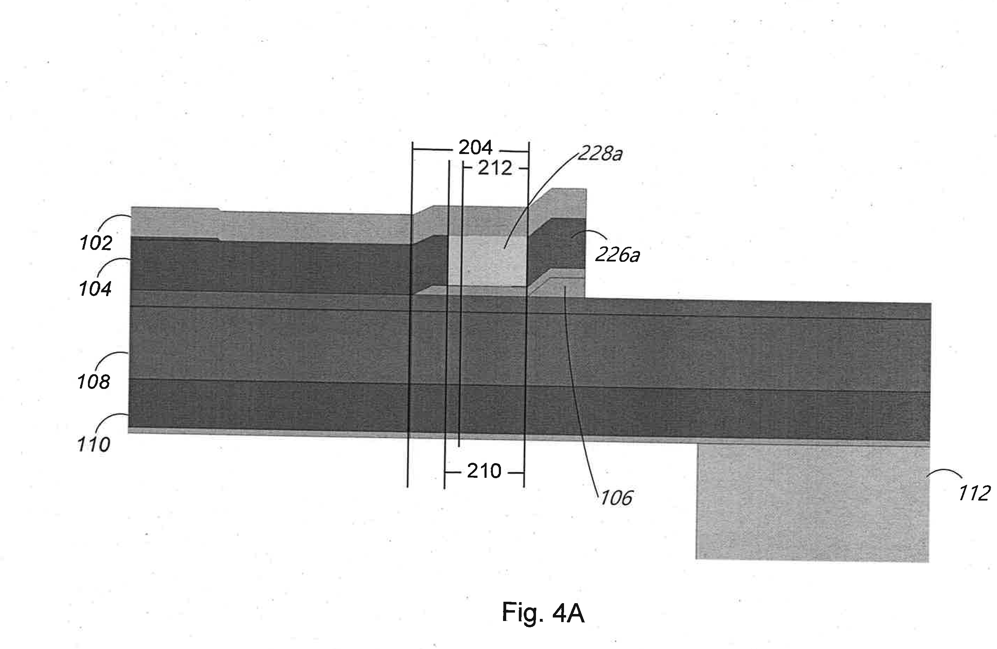

The anti-boundary mode region 210 can be formed in alternative ways than thinning one or more layers of the first region 208 of the first wall 204 of the frame 200. For example, turning next to FIGS. 4A-4C, the anti-boundary mode region 210 can be formed by substituting a second material 228 for a first material 226 in one or more of the first electrode layer 104, the piezoelectric layer 108, or the second electrode layer 110 of the first region 208 of the frame 200 or the first region 208 of the first wall 204 of the frame 200. In various cases, the anti-boundary mode region 210 can be formed by substituting the second material 228 for a first material 226 in multiple layers.

For example, as shown in FIG. 4A, FIG. 4A shows that a first material 226a of the first electrode layer 104 is replaced with a second material 228a in the anti-boundary mode region 210. FIG. 3B shows a first material 226b of the piezoelectric layer 108 is replaced with a second material 228b in the anti-boundary mode region 210. FIG. 3C shows that a first material 226c of the second electrode layer 110 is replaced with a second material 228c in the anti-boundary mode region 210. However, a person of ordinary skill in the art would understand that other options are possible for example the first material 226a and 226b could be replaced with the second material 228a and 228b in the first electrode layer 104 and the piezoelectric layer 108 to form the anti-boundary mode region 210.

In some instances, for the first electrode layer 104 and the second electrode layer 110, the first material 226a and 226b including molybdenum, ruthenium, tungsten, aluminum, or other material forming the first electrode 104a or the second electrode 108a could be replaced with a second different material 228b including a different metal than the metal forming the first electrode 104a or the second electrode 110a or with a dielectric material. In various instances, for the piezoelectric layer 108, the first material 226b including aluminum nitride,
aluminum scandium nitride, or other material capable of forming a piezoelectric layer, can be replaced with a second material 228b including a dielectric material. In various cases, the second material 228 could be disposed in the first electrode layer, piezoelectric layer 108, or the second electrode layer 110 as one or more layers.

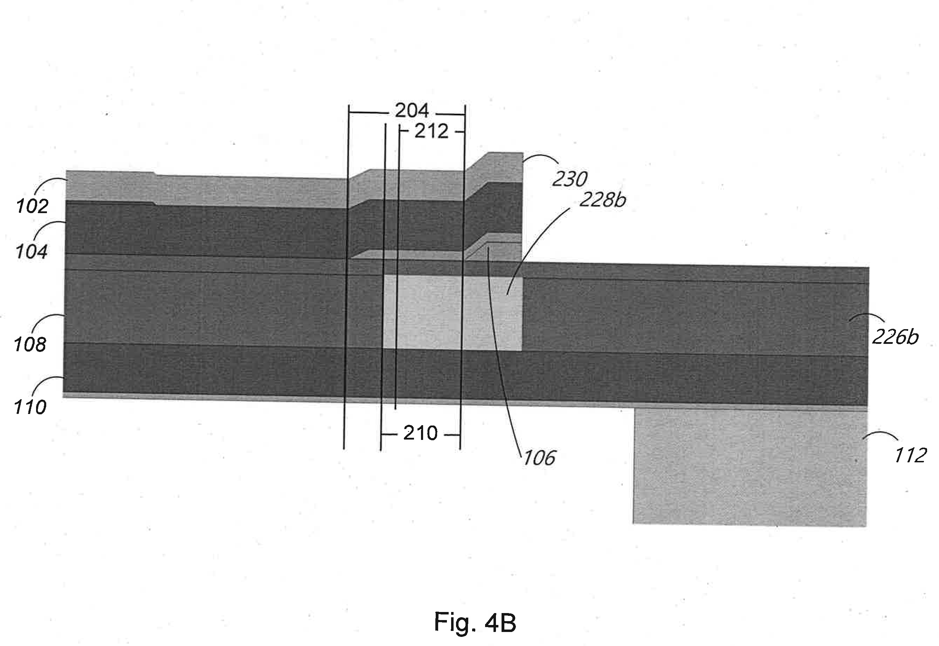

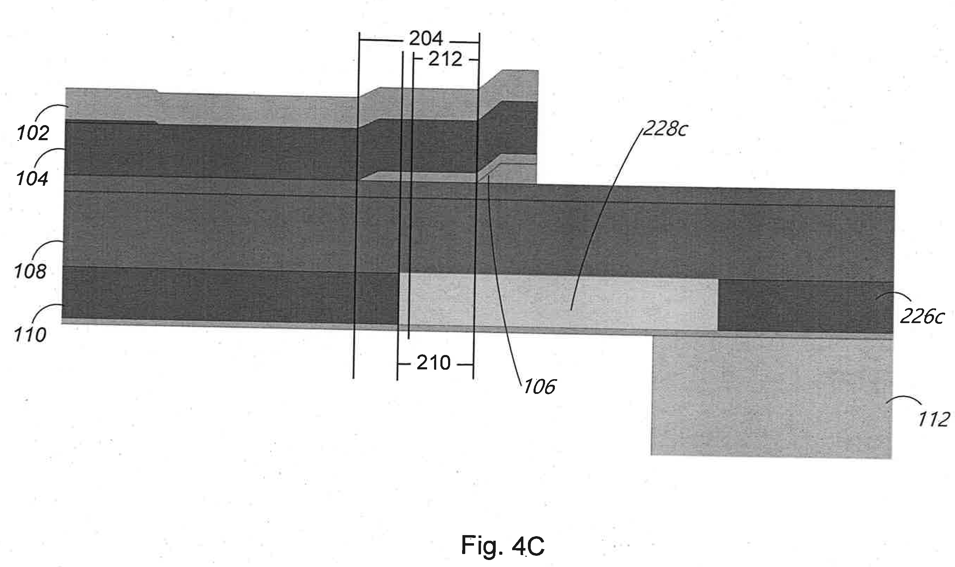

In various cases, the second material 228a, 228b, or 228c, could only extend below the first wall 204 or a portion of the first wall 204 as shown in FIG. 4A. Alternatively, the second material 228a, 228b, or 228c, could extend beyond the first wall 204 into the second wall 206 or to an edge 230 of the second wall 206 as shown in FIG. 4B. In yet other embodiments, the second material 228a, 228b, or 228c, could extend beyond the second wall 206 as shown in FIG. 4C.

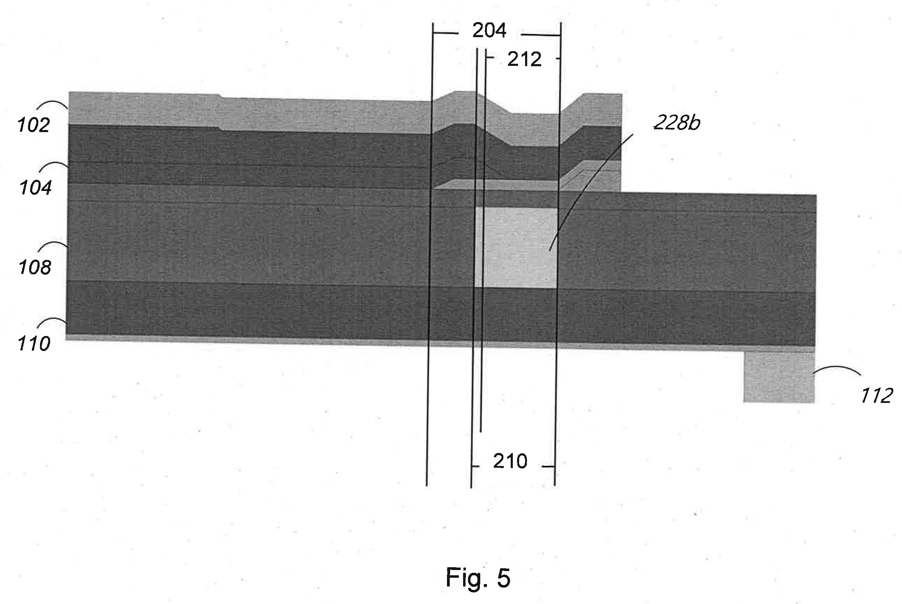

In some embodiments, as shown in FIG. 5, thinning could be used in combination with the substitution of materials to form the anti-boundary mode region 210. As shown in FIG. 5, the first electrode layer 104 is thinned while a second material 224b has been used to replace the first material 222b in the piezoelectric layer 108.

As stated above, a cutoff frequency of at least a first sub-region 212 of the anti-boundary mode region 210 is greater than an original cutoff frequency of the first sub-region 214 of the first region 208 without the anti-boundary mode region 210. Turning next to FIG. 6, FIG. 6 shows a graph 600 of the cutoff frequency of a first sub-region 214 of the first region 208 as the thickness of the first region 208 is reduced and the anti-boundary mode region 210 is formed. In this case, as the thickness of the first region 208 is reduced or thinned into the anti-boundary mode region 210, the cutoff frequency of the first region 208 increases. Thus, as the first region 208 is thinned to form the anti-boundary mode region 210, the cutoff frequency of the first sub-region 214 increases to form the first sub-region 212 of the anti-boundary mode region 210.

In FIG. 6, TE1_{original} is defined as the cutoff frequency of the original sub-region 214 of the first region 208 without the anti-boundary mode region 210 or before the anti-boundary mode region 210 is formed. TE1 is defined as the cutoff frequency of the sub-region 212 of the anti-boundary mode region 210 as a function of thinning. Fs is defined as the series resonant frequency of the acoustic resonator 100.

The acoustic resonator 100 can have a resonance frequency and an anti-resonance frequency. A resonance frequency (also referred to as a resonant frequency) may be a frequency at which the acoustic resonator 100 has a local minimum in the impedance. An anti-resonance frequency (also referred to as an anti-resonant frequency) may be a frequency at which the acoustic resonator 100 has a local maximum in the impedance. The resonance and anti-resonance frequencies can be determined by the construction of the acoustic resonator 100. For example, the frequency at which the acoustic resonator 100 resonates can be dictated at least in part by a thickness and material properties of the piezoelectric layer 108.

Cutoff frequencies of a region of the acoustic resonator 100 within a given acoustic stack (e.g., a set of layers of given thicknesses and materials forming the acoustic resonator 100 or frame 200) are given by eigenmodes (e.g., natural modes of vibration) with zero wave number (or equivalently infinite wavelength) that the stack can support. Cutoff frequencies of each region of the acoustic resonator 100 or frame 200 can be determined by taking a cross section of the acoustic resonator 100 or frame 200 and inspecting thicknesses and materials of different regions of the acoustic resonator 100 or frame 200. In other words, cutoff frequencies of each region of the acoustic resonator 100 or frame 200 can be determined after inspecting the cross section of the acoustic resonator 100 or frame 200 and analyzing the materials of each layer and the thicknesses of each layer.

In order to determine an original cutoff frequency, a cross section of the acoustic resonator 100 or frame 200 layer can be taken and a thickness of each layer (e.g., the first electrode layer, the piezoelectric layer, or the second electrode layer) can be determined in a region (e.g., in a region different that the anti-boundary mode region) that has not been thinned or in a region (e.g., in a region different that the anti-boundary mode region) where a material is different than the material in the anti-boundary mode region. Determining at least one of a thickness or a material of a region different than the anti-boundary mode region, would then allow a person of ordinary skill in the art to determine an original cutoff frequency of the anti-boundary mode region or first region before creating the anti-boundary mode region, and from this a person of ordinary skill in the art could calculate the cutoff frequencies of that first region or anti-boundary mode region, specifically its TE1 (first thickness extensional) mode cutoff frequency. In some cases, a person of ordinary skill in the art could measure the dispersion relation experimentally to obtain the cutoff frequencies using acoustic imaging. In any case, a person of ordinary skill in the art could determine the cutoff frequencies associated with the acoustic stack comprising any given region of the BAW device because a cross section of an actual device would provide the materials and thicknesses of each layer comprising the acoustic stack. Additionally, cross sections of the inner region and anti-boundary mode region would together allow the determination of an original stack of the anti-boundary mode region or first region before creating the anti-boundary mode region, and its associated original cutoff frequencies.

In the case of substitution of a second material for a first material in the anti-boundary mode region 210, TE1_{original} is defined as the cutoff frequency of the original sub-region 214 of the first region 208 when the first region 208 is formed from the first or original material (e.g., the first electrode material, the piezoelectric material, the second electrode material, etc.). TE1 is defined as the cutoff frequency of the sub-region 214 of the anti-boundary mode region 210 when the second material 228a, 228b, or 228c is substituted for the corresponding first material 226a, 226b, or 226c in the anti-boundary mode region 210.

In order to create a higher cutoff frequency in original sub-region 214, mitigate spurious modes associated with the frame 200, and still allow the frame 200 to reduce losses above fs, the sub-region 212 of the anti-boundary mode region 210 should fulfill the following ratio: $\frac{TE 1 - TE 1 original}{Fs - TE 1 original} > 0.2$

In a non-limiting example of FIG. 6, 500A of thinning would give TE1 frequency normalized to fs of 0.9. Because TE1_{original} normalized to fs equals 0.87, the ratio would equal 0.23, which is greater than the threshold ratio of 0.2. In this scenario, spurious modes associated with the frame 200 could be mitigated while still allowing the frame 200 to reduce losses above fs..

It is important to note that the entire anti-boundary mode region 210 does not need to fulfill the ratio described above. Instead, only a sub-region 214 needs to fulfill the ratio and the sub-region 214 could be a same size as the anti-boundary mode region 210 or less than the size of the anti-boundary mode region 210.

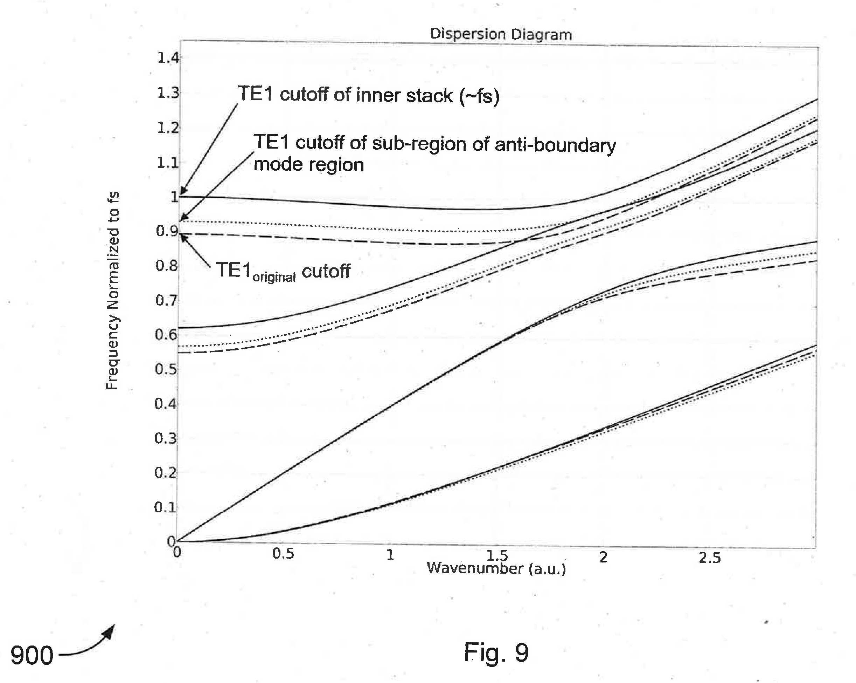

FIG. 9 shows a graph 900 of dispersion diagrams for different portions of the acoustic resonator 100. In particular, cutoff frequencies in the dispersion diagram occur when the wave number equals zero. As shown, the cutoff frequency of the acoustic resonator 100 or an inner area 118 of the acoustic resonator is 1 which is also equal to the resonant frequency (Fs) of the acoustic resonator 100. The cutoff frequency (TE1) of the sub-region 214 of the anti-boundary mode region 210 is approximately 0.92 and the original cutoff frequency (TE1_{original}) of the sub-region 214 is approximately 0.9.

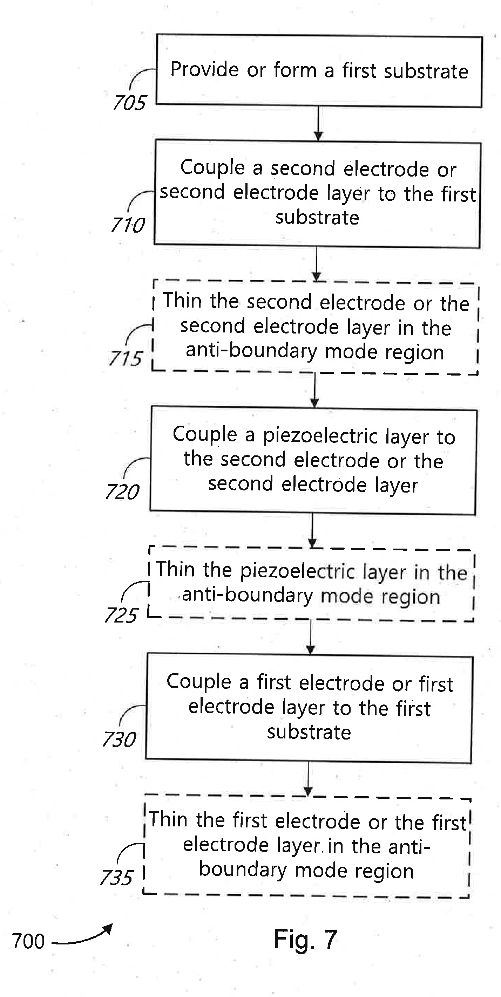

FIG. 7 is a block diagram illustrating method 700 for fabricating'an acoustic resonator 100 according to embodiments of the subject technology. This diagram merely provides an example, which should not unduly limit the scope of the claims. One of ordinary skill in the art would recognize many variations, alternatives, and modifications.

In various implementations, method 700 may be used to fabricate acoustic resonators, such as acoustic resonator 100 or portions of acoustic resonator 100 illustrated in FIGS. 1-5, which can be applied across a wide range of applications, including high-power electronics, large-scale packages, high-density integrated circuits, and/or the like. In some embodiments, method 700 may include at block 705 (e.g., manual operation or machine operation) providing a substrate (e.g., substrate 112 or the like). The method 700 may also include, at block 710, coupling or disposing a second electrode (e.g., second electrode 110a, or the like) or a second electrode layer (e.g., second electrode layer 110, or the like) to a first side of the substrate. This step can be performed by depositing the second electrode or second electrode layer on the first side of the substrate. In some cases, at optional block 715, a portion of the second electrode or second electrode layer can be thinned to form the anti-boundary mode region (e.g., anti-boundary mode region 210, or the like) of the acoustic resonator. The thinning can be performed by etching the second electrode or the second electrode layer or by another process used to thin one or more layers of a semiconductor device.

Next, at block 720, the method 700 can include coupling or disposing a piezoelectric layer (e.g., piezoelectric layer 108 or the like) to a surface of the second electrode or second electrode layer opposite the substrate. This step can be performed by depositing the piezoelectric layer on the surface of the electrode. In some cases, at optional block 725, a portion of the piezoelectric layer can be thinned to form the anti-boundary mode region (e.g., anti-boundary mode region 210, or the like) of the acoustic resonator. The thinning can be performed by etching the second electrode or the second electrode layer or by another process used to thin one or more layers of a semiconductor device.

Next, the method 700 may also include, at block 730, coupling or disposing a first electrode (e.g., first electrode 104a, or the like) or a first electrode layer (e.g., first electrode layer 104, or the like) to a surface of the piezoelectric layer opposite the second electrode or the second electrode layer. This step can be performed by depositing the first electrode or the first electrode layer on the surface of the piezoelectric layer. In some cases, at optional block 735, a portion of the first electrode or the first electrode layer can be thinned to form the anti-boundary mode region (e.g., anti-boundary mode region 210, or the like) of the acoustic resonator. The thinning can be performed by etching the first electrode or the first electrode layer or by another process used to thin one or more layers of a semiconductor device.

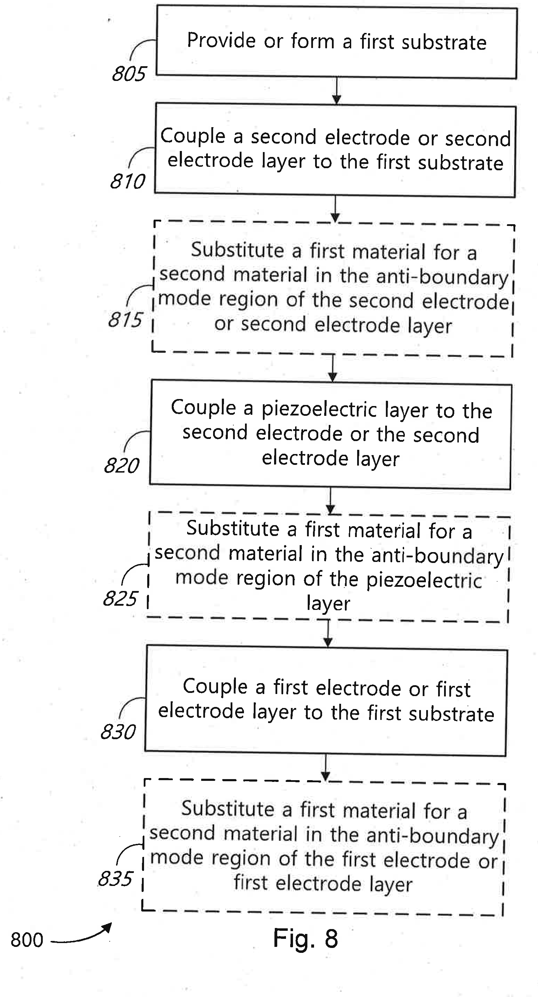

FIG. 8 is a block diagram illustrating method 800 for fabricating an acoustic resonator 100 according to embodiments of the subject technology. This diagram merely provides an example, which should not unduly limit the scope of the claims. One of ordinary skill in the art would recognize many variations, alternatives, and modifications.

In various implementations, method 800 may be used to fabricate acoustic resonators, such as acoustic resonator 100 or portions of acoustic resonator 100 illustrated in FIGS. 1-5, which can be applied across a wide range of applications, including high-power electronics, large-scale packages, high-density integrated circuits, and/or the like. In some embodiments, method 800 may include at block 805 (e.g., manual operation or machine operation) providing a substrate (e.g., substrate 112 or the like). The method 800 may also include, at block 810, coupling or disposing a second electrode (e.g., second electrode 110a, or the like) or a second electrode layer (e.g., second electrode layer 110, or the like) to a surface of the substrate. This step can be performed by depositing the second electrode or second electrode layer on the . surface of the substrate. In some cases, at optional block 815, a second material different from a first material of the second electrode or second electrode layer can be deposited or added to form the anti-boundary mode region (e.g., anti-boundary mode region 210, or the like) of the acoustic resonator. In order to perform this step, a portion of the second electrode or second electrode layer can be etched to allow deposition of the second material at the anti-boundary mode region. However, other methods may also be used to add the second material at the anti-boundary mode region.

Next, at block 820, the method 800 can include coupling or disposing a piezoelectric layer (e.g., piezoelectric layer 108 or the like) to a surface of the second electrode or second electrode layer opposite the substrate. This step can be performed by depositing the piezoelectric layer on the surface of the electrode. In some cases, at optional block 825, a second material different from a first material of the piezoelectric layer can be deposited or added to form the anti-boundary mode region (e.g., anti-boundary mode region 210, or the like) of the acoustic resonator. In order to perform this step, a portion of the piezoelectric layer can be etched to allow deposition of the second material at the anti-boundary mode region. However, other methods may also be used to add the second material at the anti-boundary mode region.

Next, the method 800 may also include, at block 830, coupling or disposing a first electrode (e.g., first electrode 104a, or the like) or a first electrode layer (e.g., first electrode layer 104, or the like) to a surface of the piezoelectric layer opposite the second electrode or the second electrode layer. This step can be performed by depositing the first electrode or the first electrode layer on the surface of the piezoelectric layer. In some cases, at optional block 835, a second material different from a first material of the first electrode or the first electrode layer can be deposited or added to form the anti-boundary mode region (e.g., anti-boundary mode region . 210, or the like) of the acoustic resonator. In order to perform this step, a portion of the first electrode or the first electrode layer can be etched to allow deposition of the second material at the anti-boundary mode region. However, other methods may also be used to add the second material at the anti-boundary mode region.

While the above is a full description of the specific embodiments, various modifications, alternative constructions and equivalents may be used. Therefore, the above description and illustrations should not be taken as limiting the scope of the subject technology which is defined by the appended claims.

## Claims

1. An acoustic resonator comprising:
a first electrode;
a layer of piezoelectric material coupled to the first electrode; and
a second electrode coupled to the layer of piezoelectric material, wherein the layer of piezoelectric material is between the first electrode and the second electrode; and
a frame located on an outer perimeter of an inner area of at least one of the first electrode, the layer of piezoelectric material, or the second electrode, at least partially framing the inner area, and formed by one or more of the first electrode, the layer of piezoelectric material, and the second electrode, and/or
wherein the frame includes an anti-boundary mode region, wherein a cutoff frequency of a first sub-region of the anti-boundary mode region is greater than an original cutoff frequency of the first sub-region without the anti-boundary mode region.

2. The acoustic resonator of claim 1, wherein a ratio of a difference between the cutoff frequency of the first sub-region of the frame with the anti-boundary mode region and an original cutoff frequency of the first sub-region of the frame without the anti-boundary mode region divided by a difference between a resonant frequency of the acoustic resonator and the original cutoff frequency of the first sub-region of the frame without the anti-boundary mode region is greater than 0.2.

3. The acoustic resonator of claim 1 or 2, wherein at least one of a first portion of the first electrode, the layer of piezoelectric material, or the second electrode is thinner in the anti-boundary mode region than a second portion of the first electrode, the layer of piezoelectric material, or the second electrode in a first region of the frame different from the anti-boundary mode region.

4. The acoustic resonator of any preceding claim, wherein the frame includes a first wall and the first wall includes the anti-boundary mode region, wherein a lower surface of the anti-boundary mode region is lower than an upper surface of a first portion of the first wall.

5. The acoustic resonator of claim 4, wherein a first sidewall of the first wall slopes downward from the upper surface of the first portion of the first wall to a lower surface of the anti-boundary mode region to form the anti-boundary mode region.

6. The acoustic resonator of any preceding claim, wherein a first wall is located between a first channel and a second wall, wherein the first channel is located toward an inner area of the acoustic resonator.

7. An acoustic resonator comprising:
a first layer including a first electrode;
a second layer including piezoelectric material coupled to the first electrode; and
a third layer including second electrode coupled to the second layer, wherein the second layer is between the first layer and the third layer; and
a frame located on an outer perimeter of an inner area of at least one of the first layer, the second layer, or the third layer, at least partially framing the inner area, and formed by one or more of the first layer, the second layer, and the third layer,
wherein the frame includes an anti-boundary mode region, wherein a first portion of at least one of the first layer, the second layer, or the third layer in the anti-boundary mode region is thinner or includes a different material than a corresponding second portion of the first layer, the second layer, or the third layer of the frame outside of the anti-boundary mode region.

8. The acoustic resonator of claim 7, wherein a ratio of a difference between a cutoff frequency of a first sub-region of the frame with the anti-boundary mode region and an original cutoff frequency of the first sub-region of the frame without the anti-boundary mode region divided by a difference between a resonant frequency of the acoustic resonator and the original cutoff frequency of the first sub-region of the frame without the anti-boundary mode region is greater than 0.2.

9. The acoustic resonator of claim 7 or 8, wherein the frame includes a first wall between the inner area and a second wall and the first wall includes the anti-boundary mode region, wherein a first thickness of at least one of the first layer, the second layer, or the third layer in the anti-boundary mode region is less than a second thickness of a corresponding layer in a first portion of the first wall of the frame, wherein the first portion of the first wall is located between the inner area and the anti-boundary mode region.

10. The acoustic resonator of claim 9, wherein the first thickness of the first layer in the anti-boundary mode region is less than the second thickness of the first layer in the first portion of the wall.

11. The acoustic resonator of claim 9 or 10, wherein the first thickness of the second layer in the anti-boundary mode region is less than the second thickness of the second layer in the first portion of the wall.

12. The acoustic resonator of any preceding claim 9 to 11, wherein the first thickness of the third layer in the anti-boundary mode region is less than the second thickness of the third layer in the first portion of the wall.

13. The acoustic resonator of any preceding claim 7 to 12, wherein a first material of at least one of the first layer, the second layer, or the third layer in the anti-boundary mode region is different than a second material of a corresponding layer in a first portion of the frame, wherein the first portion of the frame is located between the inner area and the anti-boundary mode region.

14. The acoustic resonator of any preceding claim 7 to 13, wherein a first material of the first layer in the anti-boundary mode region is different than a second material of the first layer in a first portion of the frame, wherein the first portion of the frame is located between the inner area and the anti-boundary mode region.

15. An acoustic resonator comprising:
a first electrode;
a layer of piezoelectric material coupled to the first electrode; and
a second electrode coupled to the layer of piezoelectric material, wherein the layer of piezoelectric material is between the first electrode and the second electrode; and
a frame located on an outer perimeter of an inner area of at least one of the first electrode, the layer of piezoelectric material, or the second electrode, at least partially framing the inner area, and formed by one or more of the first electrode, the layer of piezoelectric material, and the second electrode,
wherein a ratio of a difference between a cutoff frequency of a first sub-region of the frame with an anti-boundary mode region and an original cutoff frequency of the first sub-region of the frame without the anti-boundary mode region divided by a difference between a resonant frequency of the acoustic resonator and the original cutoff frequency of the first sub-region of the frame without the anti-boundary mode region is greater than 0.2.
